Europäisches Patentamt

(19) European Patent Office    (11) Publication number: **0 095 979**

Office européen des brevets                    **B1**

(12)                    **EUROPEAN PATENT SPECIFICATION**

(45) Date of publication of patent specification: **29.10.86**    (51) Int. Cl.⁴: **H 03 K 19/195**

(21) Application number: **83401069.6**

(22) Date of filing: **27.05.83**

(54) Josephson logic circuit.

(30) Priority: **31.05.82 JP 92802/82**
**28.12.82 JP 229707/82**

(43) Date of publication of application:
**07.12.83 Bulletin 83/49**

(45) Publication of the grant of the patent:
**29.10.86 Bulletin 86/44**

(84) Designated Contracting States:
**DE FR GB**

(56) References cited:
**EP-A-0 081 922**

**IEEE TRANSACTIONS ON ELECTRON DEVICES, vol. ED-27, no. 10, October 1980, pages 1857-1869, IEEE, New York, US T.R. GHEEWALA: "Josephson-logic devices and circuits"**

**IBM TECHNICAL DISCLOSURE BULLETIN, vol. 24, no. 3, August 1981, pages 1545-1546, New York, US S.M. FARIS et al.: "Compact three-terminal Josephson switch**

**IEEE TRANSACTIONS ON ELECTRON DEVICES, vol. ED-29, no. 3, March 1982, pages 414-417, IEEE, New York, US TSING-CHOW WANG et al.: "A three Josephson junction direct coupled isolation device"**

(73) Proprietor: **FUJITSU LIMITED**
**1015, Kamikodanaka Nakahara-ku**
**Kawasaki-shi Kanagawa 211 (JP)**

(72) Inventor: **Ohori, Tatsuya**
**1781, Kamitsuruma**
**Sagamihara-shi Kanagawa 228 (JP)**

(74) Representative: **Descourtieux, Philippe et al**
**CABINET BEAU de LOMENIE 55 rue d'Amsterdam**
**F-75008 Paris (FR)**

(56) References cited:
**APPLIED PHYSICS LETTERS, vol. 40, no. 8, 15th April 1982, pages 741-744, American Institute of Physics, New York, US J. SONE et al.: "Resistor coupled Josephson logic"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Background of the invention
### Field of the invention

The present invention relates to a Josephson logic circuit. Especially, it relates to a logic circuit which is effective for forming an OR circuit, an AND circuit, or a majority logic circuit.

### Description of the prior art

To rapidly process information, an electronic apparatus such as an electronic computer should operate rapidly and should be small in size.

Therefore, a Josephson element which has a much higher operation speed than does a conventional semi-conductor integrated circuit element should be considered for use as a functional element of an electric computer.

A Josephson junction device including a Josephson element connected both to an input terminal for receiving an input signal and to a current source for receiving a constant current is described in EP—A1—0 081 922, which document has a priority date earlier than that of the present application, but has been published thereafter (Art. 54(3) EPC). However, no description can be found in EP—A1—0 081 922 relative to a Josephson circuit effective for forming either an OR circuit, an AND circuit or a majority logic circuit.

As a logic circuit which utilizes such a Josephson element as a functional element, a logic circuit of current injection type of logic circuit has been proposed. An AND circuit using current injection type of logic circuit has a high input current margin. However, a separation between the input and the output is not provided and, therefore, the AND circuit must be combined with an OR circuit.

As an AND circuit which utilizes a Josephson element, a circuit including an asymmetrical Superconducting Quantum Interference Device (SQUID) element has also been proposed. However, in such an AND circuit, due to the threshold characteristics of the SQUID, the input signal level is dependant on the bias current level, with the result that the margin of operation is small.

Different logic circuits using Josephson elements are disclosed by J. Sone et al in "Applied Physics Letters" Vol. 40, No. 8, pages 741—744. In particular, an AND circuit is shown having a first Josephson element connected between a first input terminal and ground and second Josephson element connected between a second input terminal and ground. First and second resistors are serially connected between the first and second input terminal. The node of the first and second resistors forms an output terminal connected to ground through a third Josephson element.

In such an AND circuit a large amount of current is required to operate the AND circuit. Therefore, the whole output of a logic gate, for example an OR circuit forming the stage preceding the AND circuit, should be injected into the AND circuit. Consequently, the number of outputs of the logic gate is limited to one. By contrast, if it would have been possible to operate the AND circuit on a small output amount of the preceding OR circuit, then a plurality of logic circuits or logic gates could have been operated on the full output of the OR circuit.

### Objects and summary of the invention

An object of the present invention is to provide a novel Josephson logic circuit from which can be formed an AND circuit and a majority logic circuit in which the input and the output are separated and the input signal level is not dependent on the bias current level.

Another object of the present invention is to provide a novel Josephson logic circuit from which a OR circuit having a high input-output gain can be formed.

A further object of the present invention is to provide a novel Josephson logic circuit from which can be formed an AND circuit and a majority logic circuit having a very simple construction and operating on a smaller current level than that of the prior art so that the number of outputs of the logic gate connected to the previous stage of the AND circuit can be increased.

According to one aspect of the present invention, a Josephson logic circuit is provided comprising at least a first and a second input terminal, a Josephson element inserted between the input terminals and a reference electric potential and resistor means inserted between the input terminals and an input of a next stage of the Josephson logic circuit, said logic circuit being characterized in that said Josephson element is further connected to a current source to be supplied with a predetermined offset current, whereby said circuit can operate as an AND circuit or an OR circuit for the signals received on the input terminals depending on the set value of the offset current with respect to the critical current of the Josephson element.

According to another aspect of the invention, a Josephson logic circuit is provided comprising a first Josephson element connected between a first input signal line and a reference electric potential, a second Josephson element connected between a second input signal line and the reference electric potential, a first resistor and a second resistor connected in series between said first input signal line and said second input signal line, a third Josephson element connected between the node of said first and second resistors and the reference electric potential, and an output signal line led out of the node of said first and second resistors, said logic circuit being characterized in that each of said first and second Josephson elements is further connected to a current source to be supplied with a predetermined offset current, whereby the sensitivity of the Josephson logic circuit can be adjusted as a function of the value of the offset currents with respect to the critical currents of the first and second Josephson elements.

Further features and advantages of the present invention will be apparent from the ensuing description, made with reference to the accompanying drawings, to which, however, the scope of the invention is in no way limited.

Brief description of the drawings

Figure 1A illustrates the construction of a Josephson logic circuit including a characteristic feature of the present invention.

Figure 1B is a diagram illustrating the threshold characteristics of the Josephson logic circuit shown in Fig. 1A.

Figure 2A is a circuit comprising an embodiment of the present invention.

Figure 2B is a diagram illustrating the threshold characteristics of the circuit shown in Fig. 2A.

Figure 3A is a circuit comprising another embodiment of the present invention.

Figure 3B is a diagram illustrating the threshold characteristics of the circuit shown in Fig. 3A.

Figure 4 is a diagram of a connection formed by integrating a plurality of Josephson logic circuits according to the present invention.

Figure 5A is a circuit comprising a conventional AND circuit which utilizes Josephson elements.

Figure 5B is a diagram illustrating the threshold characteristics line and the operation of the circuit shown in Fig. 5A.

Figure 6A is a circuit comprising an embodiment of an AND circuit according to the present invention.

Figure 6B is diagram illustrating the threshold characteristic line and the operation area of the circuit shown in Fig. 6A.

Figures 7A and 7B are diagrams illustrating the construction of a conventional circuit. Figure 7C is a diagram illustrating the construction of a circuit according to the present invention.

Figure 8 is a circuit comprising a conventional majority logic circuit which utilizes Josephson elements.

Figure 9 is a circuit comprising a majority logic circuit which utilizes Josephson elements according to the present invention.

Description of the preferred embodiments

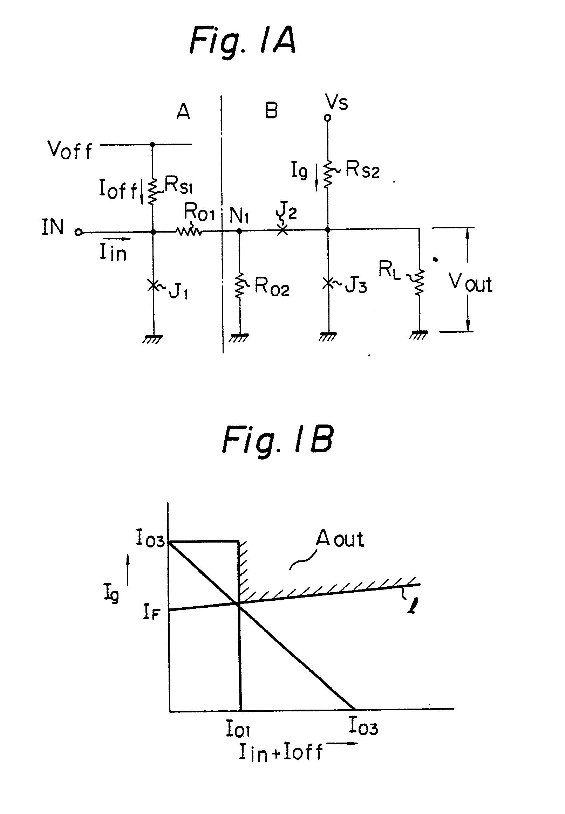

Figure 1A illustrates the construction of a Josephson logic circuit including a characteristic feature of the present invention. In Fig. 1A, $J_1$, $J_2$, and $J_3$ designate Josephson elements, each of the Josephson elements having critical currents of $I_{01}$, $I_{02}$, and $I_{03}$, respectively. $R_{01}$ and $R_{02}$ designate resistors having a relatively small resistance value, such as 0.5 to 1 [$\Omega$] and $R_{S1}$ and $R_{S2}$ designate resistors having a relatively large resistance value, such as 30 to 40 [$\Omega$]. $R_L$ designates a load resistance, and $V_S$ designates a supply voltage. $I_g$ designates a gate current, $V_{off}$ designates an offset voltage, $I_{off}$ designates an offset current, and $I_{in}$ designates an input signal current.

In Fig. 1A, the portion A forms an input circuit portion which constitutes a characteristic feature of the present invention, and the portion B forms an output logic circuit which is conventionally used. Such output logic circuit is the logic circuit which is called as JAWS (Josephson Atto Weber Switch). Therefore, the node $N_1$ forms the input point for the output logic circuit portion B.

In such a construction, when the sum of the input signal current $I_{in}$ and the offset current $I_{off}$ has a value which does not exceed the critical current of the Josephson element $J_1$, the input signal current $I_{in}$ flows into the Josephson element $J_1$ towards the reference electric potential such as the ground potential and the gate current $I_g$ flows into the Josephson element $J_3$ toward the reference electric potential such as the ground potential.

When the sum of the input signal current $I_{in}$ and the offset current $I_{off}$ exceeds the critical current value of the Josephson elements $J_1$, the Josephson element $J_1$ assumes a non-zero voltage state (a high resistance state) and the sum the input signal current $I_{in}$ and the offset current $I_{off}$ flows via the Josephson element $J_2$ into the Josephson element $J_3$, with the result that the Josephson element $J_3$ assumes a non-zero voltage state.

Because the Josephson element $J_3$ assumes a non-zero voltage state, the current

$$I_{in} + I_g + I_{off}$$

flows in the resistor $R_{02}$ and the load resistor $R_L$. If the ratio $R_L/R_{02}$ is selected as a sufficiently large value, the greater part of the current $I_g$ flows into the Josephson element $J_2$ and the resistor $R_{02}$ towards the reference electric potential, with the result that the Josephson element $J_2$ assumes a non-zero voltage state.

When the Josephson element $J_2$ assumes a non-zero voltage state, the gate current $I_g$ flows into the load resistor $R_L$, with the result that the output voltage $V_{out}$ appears between two terminals of the load resistor $R_L$.

That is, in a Josephson logic circuit according to the present invention, the input signal current and the gate current flow independently of each other until the value of the input signal current reaches the threshold value, and when the input signal current exceeds the threshold value, the input signal is injected into the Josephson element $J_3$ where the gate current flows. Therefore, if the offset current $I_{off}$ which sets the threshold value of the input signal current is suitable selected, a circuit which is suitable for use as an AND circuit or OR circuit can be constructed.

Therefore, according to the present invention, a circuit which can suitably form an AND circuit or an OR circuit can be constructed by selecting the value of the offset current $I_{off}$ which sets the threshold value of the input signal current.

Figure 1B shows the characteristics of the threshold value of the logic circuit shown in Fig. 1A. In Fig. 1B, the ordinate designates the gate

current $I_g$ and the abscissa designates the sum the input signal current $I_{in}$ and the offset current $I_{off}$.

In the logic circuit shown in Fig. 1A, the allowable gate current is determined by the critical current $I_{03}$ of the Josephson element $J_3$, and the threshold value of the input signal current $I_{in}$ is determined, as has already been mentioned, by the value $I_{01} - I_{off}$.

Therefore, when the Josephson element $J_1$ is in a non-zero voltage state, the condition in which the output voltage $V_{out}$ appears can be shown by following equations:

$$(1) \qquad I_g + I_{in} + I_{off} > I_{03}$$

$$(2) \qquad \frac{R_L}{R_L + R_{02}} I_g - \frac{R_{02}}{R_L + R_{02}} (I_{in} + I_{off}) > I_{02}$$

Further, in Fig. 1B,

$$I_F = \frac{R_L + R_{02}}{R_L} I_{02}$$

Therefore, in Fig. 1B, the hatched area $A_{out}$ shows the range of $I_{in}$ and $I_g$ in which the output voltage $V_{out}$ appears.

Further, for the purpose of realizing good separation between the input and the output and of obtaining a large bias margin (that is, the inclination of the line I is made small), the value of the resistors $R_{01}$ and $R_{02}$ preferably is made small in the range where the Josephson element $J_1$ is operated in the latching mode.

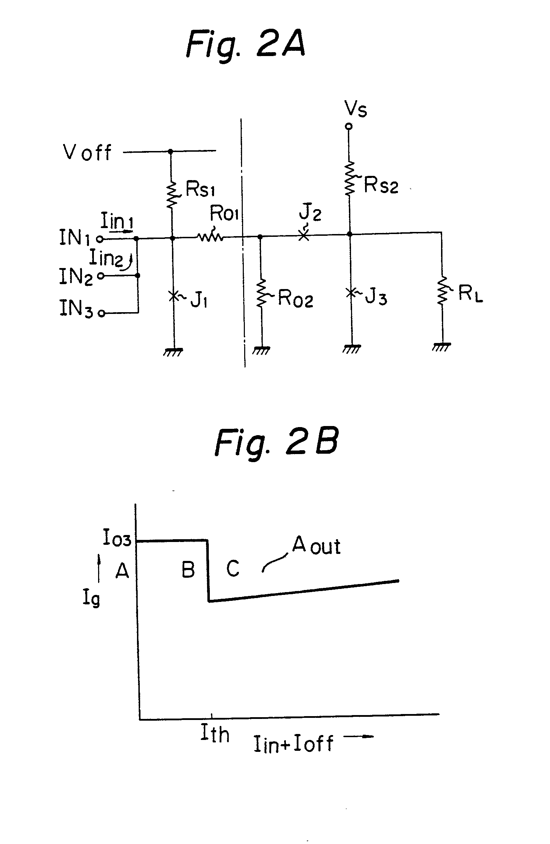

Figure 2A shows a logic circuit which is used as an AND circuit according to the present invention, and Fig. 2B shows the condition for setting the threshold value in the circuit shown in Fig. 2A.

That is, when the offset current $I_{off}$ is made zero or very small, the threshold value $I_{th}$ of the input signal current $I_{in}$ is made large, and the input signals $I_{in1}$ and $I_{in2}$ are injected into the input terminals $IN_1$ and $IN_2$ after the operational point A is set, as is shown in Fig. 2B, the relationship

$$I_{in1} + I_{in2} > I_{th}$$

is obtained (as is shown point c in Fig. 2B), and the output voltage $V_{out}$ is obtained. If the input signal current is supplied to only the input terminal $IN_1$ or $IN_2$, the relationship between $I_g$ and $I_{in}$ remains at point B, shown in Fig. 2B, with the result that the output voltage $V_{out}$ cannot be obtained.

That is, an AND circuit is formed. Further, in Fig. 2A, when a third input terminal $IN_3$ is provided so as to supply the input signal current, a two-thirds majority logic circuit can be formed. In such an AND circuit, which is different than the conventional AND circuit formed from a conventional current inject-type logic circuit, separation of the input and the output is possible, and no combination with an OR circuit is necessary.

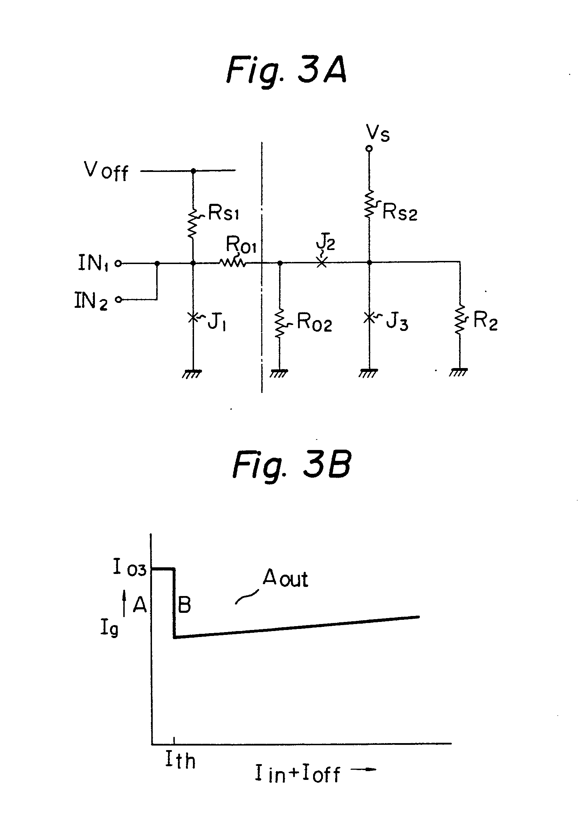

Figure 3A shows a logic circuit used as an OR circuit according to the present invention, and Fig. 3B shows the condition for setting the threshold value.

That is, in such an OR circuit, the value of the offset current $I_{off}$ is made large compared with the already mentioned AND circuit, and the threshold value ($I_{th}$) of the input signal current $I_{in}$ is made small.

When the threshold value ($I_{th}$) is set in such a manner and the input signal current $I_{in1}$ or $I_{in2} > I_{th}$ is supplied to one of the input terminals $IN_1$ and $IN_2$, the output voltage $V_{out}$ can be obtained.

That is, according to the present invention, an AND circuit, a majority circuit, or an OR circuit can be formed by setting the offset current of the input signal current.

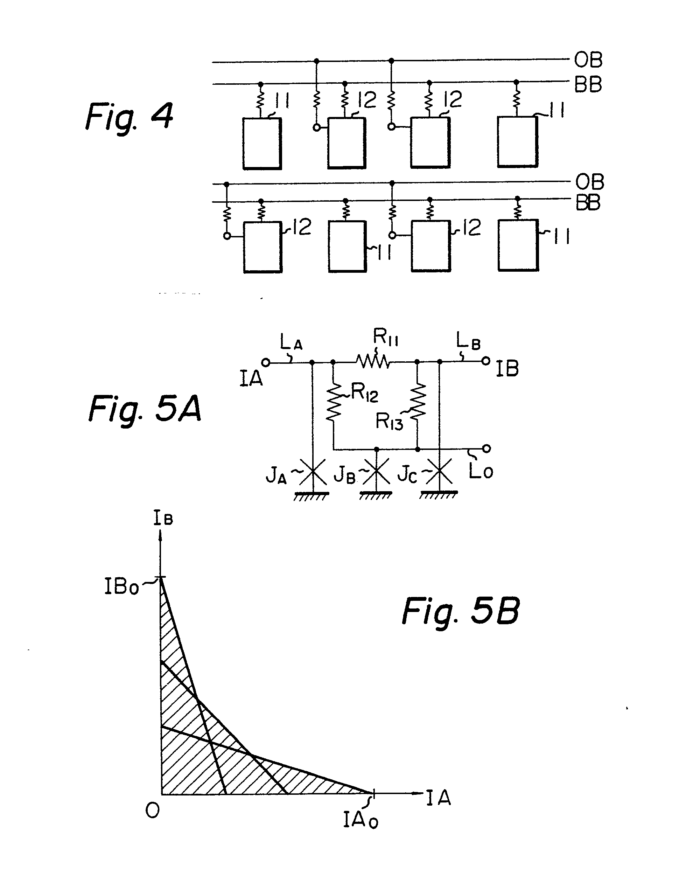

Further, when a plurality of logic circuits according to the present invention is integrated, and when the offset current, supplied or not, is selected an AND circuit and an OR circuit, etc. can be formed from a large-scale Josephson integrated circuit which has a master-slice construction. Figure 4 shows the outline of the construction of such a circuit. In Fig. 4, the input terminal and the output terminal of each logic circuit are not shown, and 11 designates an AND circuit, 12 designates an OR circuit. OB designates an offset bus line, and BB designates a bias bus line.

Further, in the Josephson logic circuit of the present invention, the input circuit portion A in Fig. 1A can be combined not only with the Josephson output logic circuit portion B in Fig. 1A but also with any other Josephson logic circuit, with the result that the threshold value of such a logic circuit can be set in a suitable condition. That is, the logic circuit may be formed, beside aforementioned JAWS, other wellknown circuits, such as 4JL, DCL (Direct Coupled logic) or RCJL (Resistor Coupled Josephson Logic).

Concerning the above-mentioned logic circuit, JAWS is disclosed, for example, in the article, "Current switched Josephson latching logic gates with sub-100ps delays" in "IEEE TRANSACTIONS ON MAGNETICS, Vol. MAG-15, No. 6, November, 1979" pp. 1886 to 1888.

Further, DCL is disclosed, for example, in the article "Josephson-logic device circuits. B. Device-coupled isolation (DCI) device", p, 1,860, right column to p. 1,862, left column in "IEEE TRANSACTIONS ON ELECTRON DEVICES, Vol. ED-27, No. 10, October 1980" pp. 1857 to 1869.

Also, RCJL is disclosed, for example, in the article "Resistor coupled Josephson logic" in "Applied Physics Letters" 40(8), 15 April 1982, pp. 741 to 744.

As has already been mentioned, according to the circuit shown in Figs. 2A and 2B, an AND circuit which can separate the input and the output and which has an input signal level independent of the bias current level and an OR circuit which has a high gain can be constructed from one circuit. Therefore, when a Josephson integrated circuit is formed with such an AND circuit and such an OR circuit, the Josephson circuit is very effective.

Further, Fig. 5A is a conventional Josephson logic AND circuit shown in the above mentioned article by J. Sone et al in Applied Physics Letters, Vol. 40, No. 8, pp. 741—744, and Fig. 5B is a diagram explaining the operation of the circuit shown in Fig. 5A.

In Fig. 5A, JA, JB, and JC are Josephson elements, $R_{11}$ to $R_{13}$ are resistors, LA and LB are input signal lines, and LO is an output signal line.

The threshold characteristic of the AND circuit is as is shown in Fig. 5B.

In Fig. 5B, IA is a current which is input in the input signal line LA, $IA_0$ is a critical current, IB is a current which is input into the input signal line LB, and $IB_0$ is a critical current.

In this conventional example, the output cannot appear inside the hatched portion shown in Fig. 5B. The output appears outside of the hatched portion. Therefore, for example, when the input is applied to the input signal line LA but is not applied to the input signal line LB, the output does not appear. Even in the opposite case, the output does not appear. The output appears when both input signal lines LA and LB receive the input, and thereby the AND operation is carried out.

It is assumed that when the area outside the hatched portion in Fig. 5B is increased, the working margin is increased.

Junction area in the Josephson element is set by the design, and the value of the critical current is determined by the set of such junction area. Therefore, the decrease of the critical currents $IA_0$ and $IB_0$ in the Josephson element is limited.

Because the critical currents $IA_0$ and $IB_0$ are large, as was mentioned above, to operate this AND circuit, the flow of a large current is necessary, with the result that the whole output of the logic gate, that is, for example, an OR circuit connected to the previous stage of the AND circuit, must be injected into the AND circuit. Therefore, the number of outputs of the logic gate is limited to one.

If the AND circuit can be operated on a small output of the OR circuit connected to the previous stage of the AND circuit, then a plurality of logic circuits can be operated on the full output of the OR circuit.

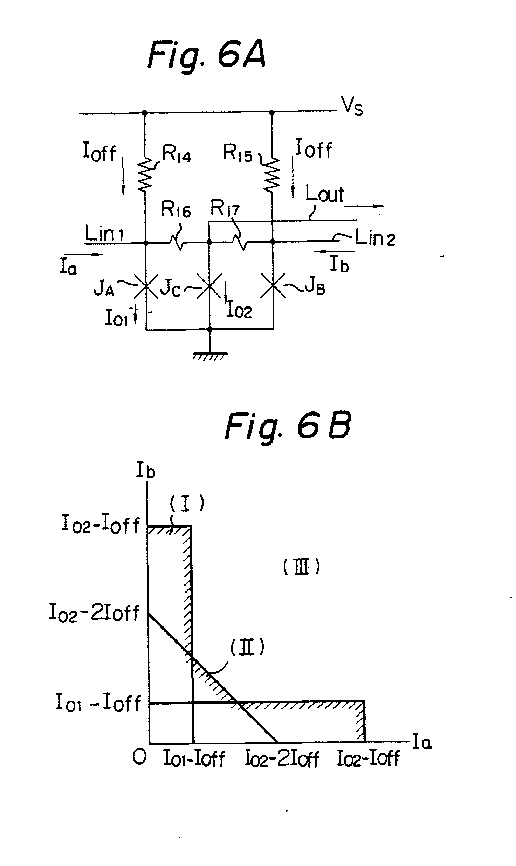

Figure 6A is a circuit diagram illustrating an essential portion of an embodiment of the present invention, and Fig. 6B is a diagram illustrating the threshold characteristics of the embodiment shown in Fig. 6A.

In Fig. 6A, $R_{14}$ to $R_{17}$ are resistors $J_A$, $J_B$, and $J_C$ are Josephson elements (first, second, and third Josephson elements), $L_{out}$ is an output signal line, $L_{in1}$ and $L_{in2}$ are a first input signal line and a second input signal line, respectively, $V_s$ is a constant supply voltage for the circuit, $I_{off}$ is an offset current, $I_a$ and $I_b$ are input signal currents, and $I_{01}$ and $I_{02}$ are critical currents of the Josephson elements $J_A$, $J_B$, and $J_C$. In Fig. 6A, resistors $R_{14}$ and $R_{15}$ are constant current resistors and resistors $R_{16}$ and $R_{17}$ are separation resistors.

Next, the operation of the embodiment shown in Fig. 6A is explained with reference to Fig. 6B considering the following conditions:

(1)

$$0 \leq I_a < I_{01} - I_{off}$$

and

$$I_{01} - I_{off} \leq I_b < I_{02} - I_{off}$$

(the area I in Fig. 6B).

In such an area I, the Josephson element $J_B$ is switched to a non-zero voltage state and the current $I_{off} + I_b$ flows into the Josephson element $J_C$. However, the Josephson element $J_C$ is not switched, with the result that no output appears on the output signal line $L_{out}$.

(2)

$$I_{01} - I_{off} < I_a, \ I_b$$

and

$$I_{02} - 2I_{off} > I_a + I_b$$

(the area Ii in Fig. 6B).

In such an area II, the Josephson elements $J_A$ and $J_B$ are switched. However, the current which flows into the Josephson element $J_C$ does not exceed the critical current $I_{02}$, and, therefore, no output appears.

(3)

$$I_{01} - I_{off} < I_a, \ I_b$$

and

$$I_{02} - 2I_{off} < I_a + I_b$$

(the area III in Fig. 6B).

In such an area III, the Josephson elements $J_a$, $J_B$, and $J_C$ are all switched, and, therefore, an output appears.

As is apparent from the above explanation, the line which separates the hatched portion and the non-hatched portion in Fig. 6B is the threshold characteristics curve.

Now, referring to the embodiment shown in Fig. 6A, it is very easy to decrease the threshold level of the AND gate. For example, to decrease the current $I_{02} - I_{off}$ corresponding to the critical current $I_{B0}$ shown in Fig. 5B, the current $I_{off}$ may be increased, and the current $I_{off}$ may be adjusted at will because it is supplied from the exterior. It should be understood that the other critical currents may be dealt with in the same manne.

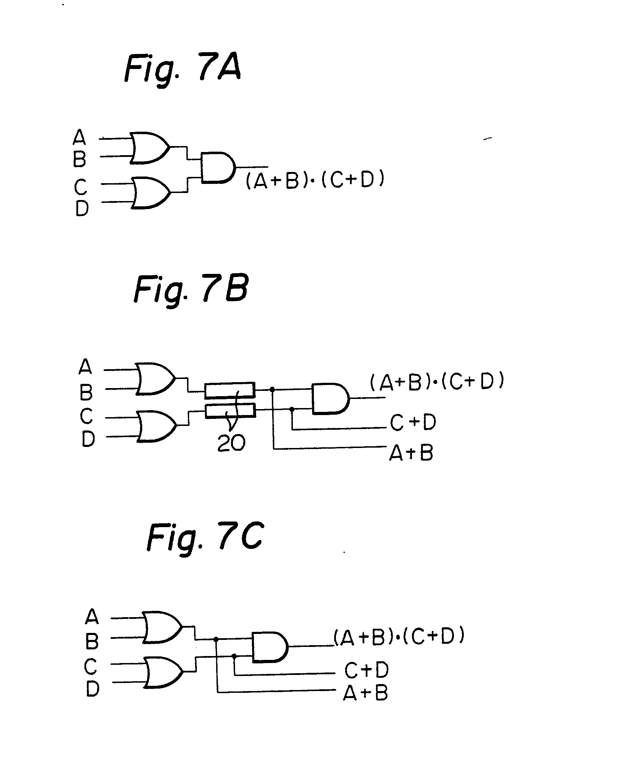

Figure 7A is a block diagram illustrating the connection between conventional OR circuits and an AND circuit. In Fig. 7A, A, B, C, and D designate input signals.

To drive the conventional AND circuit shown in Fig. 7A, a comparatively large current level is necessary, as was mentioned above. Therefore, as is apparent from Fig. 7A, all of the outputs of OR circuits connected in the previous stage of the AND circuit should be connected to the AND circuit so that the number of fan-outs of the OR circuits connected in the previous stage to the AND circuit is limited to one.

If it is necessary that the outputs of the OR circuits be connected to a plurality of logic circuits by using conventional AND circuits, the outputs of the OR circuits must be amplified with a current amplifier 20 shown in Fig. 7B.

Figure 7C is a block diagram illustrating the connection between OR circuits and an AND circuit which is an embodiment of the present invention. In the circuit shown in Fig. 7C, as is apparent from the threshold characteristics shown in Fig. 6B, if the values of the offset current and the critical current are suitably selected, the AND operation can be carried out with a small current level. Further, since the offset current flows to the output line, the output level of the AND circuit becomes large, with the result that the logic circuit connected to the next stage of the AND circuit can be sufficiently driven. Therefore, as is shown in Fig. 7C, the number of fan-outs of the OR circuits connected to previous stage of the AND circuit can be increased.

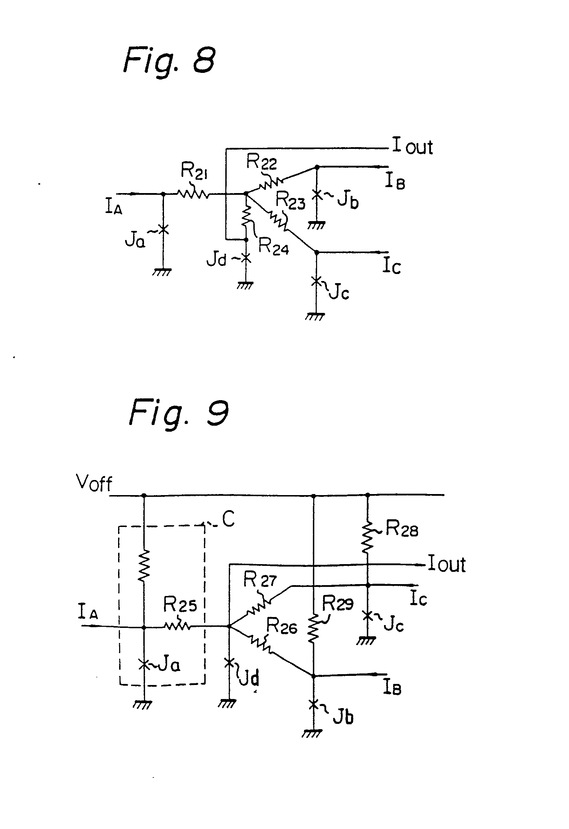

Figure 8 is a conventional two-thirds majority logical circuit which has also been reported in the already mentioned Appl. Phys. Lett., Vol. 40, No. 8, 15 April 1982 P. 741~744. In Fig. 8, $J_a$, $J_b$, $J_c$, and $J_d$ designate Josephson elements, $R_{21}$, $R_{22}$, $R_{23}$, and $R_{24}$ designate resistors, $I_A$, $I_B$, and $I_C$ designate input currents, and $I_{out}$ designates an output current. This circuit has a wide operation region. However, since all of the output currents of the logic circuits connected to the previous stage of the circuit must be injected into the circuit as the input currents $I_A$, $I_B$, and $I_C$, the number of fan-outs in the previous stage is limited to one.

Figure 9 is a circuit in which the drawback of the circuit shown in Fig. 8 is eliminated. When the portion C is removed from the circuit of Fig. 9, the circut is the same as the circuit shown in Fig. 6A. By adding the portion C to the circuit shown in Fig. 6A, a two-thirds majority logic circuit which has a high input sensitivity, due to an offset current being supplied thereto, can be obtained.

Further, as is apparent from Fig. 9, this circuit has a symmetry with respect to $I_A$, $I_B$, and $I_C$, with the result that this circuit operates as an AND circuit for $I_A$ and $I_B$, $I_B$ and $I_C$, and $I_C$ and $I_A$. That is, the logic equation of this circuit can be expressed as a two-thirds majority logical operation:

$$A \cdot B + B \cdot C + A \cdot C$$

This circuit has a characteristic which is substantially the same as that of the AND circuit shown in Fig. 6A.

In the circuits shown in Fig. 6A and Fig. 9, the Josephson logic circuit can be driven by a small current level, and, therefore, the charge of the logic gate connected to the previous stage can be decreased with the result that the number of used elements can be decreased, as can the operation time and the occupied area.

**Claims**

1. A Josephson logic circuit comprising at least a first and a second input terminal, a Josephson element inserted between the input terminals and a reference electric potential and resistor means inserted between the input terminals and an input of a next stage of the Josephson logic circuit, said circuit being characterized in that said Josephson element ($J_1$) is further connected to a current source to be supplied with a predetermined offset current ($I_{off}$), whereby said circuit can operate as an AND circuit or an OR circuit for the signals received on the input terminals ($IN_1$, $IN_2$) depending on the set value of the offset current with respect to the critical current of the Josephson element.

2. A Josephson logic circuit according to claim 1, characterized in that it includes a third input terminal ($IN_3$) so that it can operate as a two-thirds majority logic circuit.

3. A Josephson logic circuit comprising a first Josephson element ($J_A$, fig. 6A; $J_a$, fig. 9) connected between a first input signal line ($I_a$, fig. 6A; $I_A$, fig. 9) and a reference electric potential, a second Josephson element ($J_B$; $J_b$) connected between a second input signal line and the reference electric potential, a first resistor ($R_{16}$; $R_{25}$) and a second resistor ($R_{17}$; $R_{26}$) connected in series between said first input signal line and said second input signal line, a third Josephson element ($J_c$, fig. 6A; $J_d$, fig. 9) connected between the node of said first and second resistors and the reference electric potential, and an output signal line ($I_{out}$) led out of the node of said first and second resistors, said circuit being characterized in that each of said first and second Josephson elements ($J_A$, $J_B$; $J_a$, $J_b$) is further connected to a current source to be supplied with a predetermined offset current ($I_{off}$), whereby the sensitivity of the Josephson logic circuit can be adjusted as a function of the value of the offset currents with respect to the critical currents of the first and second Josephson elements.

4. A Josephson logic circuit according to claim 3, characterized in that it further comprises a fourth Josephson element ($J_c$, fig. 9) connected between a third input signal line ($I_c$) and the reference electric potential, a third resistor ($R_{27}$) connected between the node of said third input signal line and fourth Josephson element and the node of said first and second resistors ($R_{25}$, $R_{26}$), said third Josephson element ($J_c$) being further connected to a current source to be supplied with a predetermined offset current so that the Josephson logic circut can operate as a two-thirds majority logic circuit.

**Patentansprüche**

1. Josephson-Logikschaltung mit wenigstens einem ersten und einem zweiten Eingangsanschluß, einem Josephson-Element, das zwischen den Eingangsanschlüssen angeordnet ist, und einem elektrischen Referenzpotential und Widerstandseinrichtungen, die zwischen den Eingangsanschlüssen und einem Eingang einer nächsten Stufe der Josephson-Logikschaltung eingefügt sind, welche dadurch gekennzeichnet ist, daß das genannte Josephson-Element ($J_1$) ferner mit einer Stromquelle verbunden ist, um mit einem vorbestimmten Verschiebungsstrom ($I_{off}$) versorgt zu werden, wodurch die genannte Schaltung als eine UND-Schaltung oder eine ODER-Schaltung für die Signale arbeiten kann, die an den Eingangsanschlüssen ($IN_1$, $IN_2$) empfangen werden, abhängig von dem eingestellten Wert des Verschiebungsstromes in Bezug auf den kritischen Strom des Josephson-Elements.

2. Josephson-Logikschaltung nach Anspruch 1, dadurch gekennzeichnet, daß sie wenigstens einen dritten Eingangsanschluß ($IN_3$) umfaßt, so daß sie als eine Zweidrittel-Mehrheits-Logikschaltung arbeiten kann.

3. Josephson-Logikschaltung mit einem ersten Josephson-Element ($J_A$, Figur 6A; $J_a$, Figur 9), das zwischen einer ersten Eingangssignalleitung ($I_a$, Figur 6A; $I_A$, Figur 9) und einem elektrischen Potential angeschlossen ist, einem zweiten Josephson-Element ($J_B$; $J_b$), das zwischen einer zweiten Eingangsleitung und dem elektrischen Referenzpotential angeschlossen ist, einem ersten Widerstand ($R_{16}$; $R_{25}$) und einem zweitsn Widerstand ($R_{17}$; $R_{26}$), die in Reihe zwischen der genannten ersten Eingangsleitung und der genannten zweiten Eingangsleitung angeschlossen sind, einem dritten Josephson-Element ($J_c$, Fig. 6A; $J_d$, Fig. 9), das zwischen dem Knotenpunkt der genannten ersten und zweiten Widerstände und dem elektrischen Referenzpotential angeschlossen ist, und einer Ausgangs-signalleitung ($I_{out}$), die von dem Knotenpunkt der genannten ersten und zweiten Widerstände herausgeführt ist, wobei die Schaltung dadurch gekennzeichnet ist, daß jedes der ersten und zweiten Josephson-Elemente ferner mit einer Stromquelle verbunden ist, um mit einem vorbestimmten Verschiebungsstrom ($I_{off}$) versorgt zu werden, wodurch die Sensitivität der Josephson-Logikschaltung als eine Funktion des Wertes der Verschiebungsströme in Bezug auf die kritischen Ströme der ersten und der zweiten Josephson-Elemente eingestellt werden kann.

4. Josephson-Logikschaltung nach Anspruch 3, dadurch gekennzeichnet, daß sie ferner ein viertes Josephson-Element ($J_c$, Fig. 9) umfaßt, das zwischen einer dritten Eingangsleitung ($I_c$) und dem elektrischen Referenzpotential angeschlossen ist, einen dritten Widerstand ($R_{27}$), der zwischen dem Knotenpunkt der genannten dritten Eingangssignalleitung und dem vierten Josephson-Element und dem Knotenpunkt der genannten ersten und zweiten Widerstände ($R_{25}$, $R_{26}$) angeschlossen ist, wobei das dritte Josephson-Element ($J_c$) ferner mit einer Stromquelle verbunden ist, um mit einen vorbestimmten Verschiebungsstrom versorgt zu werden, so daß die Josephson-Logikschaltung als eine Zweidrittel-Mehrheits-Logikschaltung arbeiten kann.

**Revendications**

1. Circuit logique Josephson, comprenant au moins une première et une deuxième borne d'entrée, un élément Josephson inséré entre les bornes d'entrée et un potentiel électrique de référence, ainsi qu'un dispositif résistant inséré entre les bornes d'entrée et une entrée d'un étage suivant du circuit logique Josephson, caractérisé en ce que l'élément Josephson ($J_1$) est connecté en outre à une source de courant pour être alimenté avec un courant de décalage ($I_{déc}$) prédéterminé, de sorte que le circuit peut fonctionner comme un circuit ET ou un circuit OU pour les signaux reçus sur les bornes d'entrée ($EN_1$, $EN_2$), suivant l'ajustement de l'intensité du courant de décalage par rapport au courant critique de l'élément Josephson.

2. Circuit selon la revendication 1, caractérisé en ce qu'il comprend une troisième borne d'entrée ($EN_3$), de sorte qu'il peut fonctionner comme un circuit logique de majorité à deux tiers.

3. Circuit logique Josephson, comprenant un premier élément Josephson ($J_A$ figure 6A; $j_a$ figure 9) connecté entre une ligne ($I_a$ figure 6A; $I_A$ figure 9) pour un premier signal d'entrée et un potentiel électrique de référence, un second élément Josephson ($J_B$; $J_b$) connecté entre une ligne pour un deuxième signal d'entrée et le potentiel de référence, une première résistance ($R_{16}$; $R_{25}$) et une deuxième résistance ($R_{17}$; $R_{26}$) branchées en série entre les lignes pour les premier et deuxième signaux d'entrée, un troisième élément Josephson ($J_c$ figure 6; $J_d$ figure 9) connecté entre le noeud formé entre les première et deuxième résistances et le potentiel de référence, ainsi qu'une ligne ($I_{so}$) pour un signal de sortie, qui part du noeud les deux résistances, caractérisé en ce que le premier et le second élément Josephson ($J_A$, $J_B$; $J_a$, $J_b$) sont chacun connectés en plus à une source de courant constant pour être alimentés avec un courant de décalage ($I_{déc}$) prédéterminé, de sorte que la sensibilité du circuit logique Josephson peut être ajustée comme une fonction de l'intensité des courants de décalage par rapport aux courants critiques des premier et second éléments Josephson.

4. Circuit selon la revendication 3, caractérisé en ce qu'il comprend en plus un quatrième élément Josephson ($J_c$ figure 9) connecté entre une ligne ($I_c$) pour un troisième signal d'entrée et le potentiel de référence, une troisième résistance ($R_{27}$) connectée entre d'une part le noeud entre cette ligne et le quatrième élément Josephson et d'autre part le noeud entre les première et deuxième résistances ($R_{25}$, $R_{26}$), le troisième élément Josephson étant connecté en outre à une source de courant pour être alimenté avec un courant de décalage prédéterminé, de sorte que le circuit logique Josephson peut fonctionner comme un circuit logique de majorité à deux tiers.

## Fig. 1A

## Fig. 1B

# Fig. 2A

# Fig. 2B

# Fig. 3A

# Fig. 3B

*Fig. 4*

*Fig. 5A*

*Fig. 5B*

# Fig. 6A

# Fig. 6B

## Fig. 7A

$\overline{(A+B)\cdot(C+D)}$

## Fig. 7B

$(A+B)\cdot(C+D)$

20

$C+D$

$A+B$

## Fig. 7C

$(A+B)\cdot(C+D)$

$C+D$

$A+B$

# Fig. 8

# Fig. 9